# EUROPEAN PATENT APPLICATION

(11) **EP 2 017 891 A1**
(43) Date of publication of application: **21.01.2009**
(21) Application number: 07112854.0
(22) Date of filing: 20.07.2007
(51) Int. Cl.: H01L 25/16, H01L 23/24

(54) **Semiconductor module**

(71) Applicant: ABB Technology AG, 8050 Zurich (CH)
(72) Inventor: Trüssel, Dominik, 5620 Bremgarten (CH); Schneider, Daniel, 8112 Otelfingen (CH)
(74) Representative: ABB Patent Attorneys

(57) **Abstract**

A semiconductor module (1) comprises a base plate (2), at least one semiconductor chip (3) mounted on the base plate (2), a case (4) fixed to the base plate (2) and surrounds the at least one semiconductor chip (3), an electrically insulating gel layer (5) covering the at least one semiconductor chip (3) and a thermosetting resin layer (6) on top of gel layer (5), a lid (7) on top of the thermosetting resin layer (6).

The lid (7) comprises a lid-opening (71), a lid-layer (72) surrounding the lid-opening (71) and a lid-extension (73) extending from the boundary of the lid-opening (71) through the thermosetting resin layer (6) to the gel layer (5).

## Description

### Technical Field

The invention relates to the field of power electronics and more particularly to a semiconductor module according to the preamble of claim 1.

### Background Art

Semiconductor modules for high power application can comprise a housing and semiconductor chips sealed inside the housing. The housing has side walls and it is closed on one side of the side walls by a base plate, on which the semiconductor chips are arranged, and on the opposite side with a lid. In the housing, electrically insulating silicone gel filler is inserted, thus covering the chips. The lid together with the packaging resin seals the housing from the top. Typically, electrical terminals for electrically contacting the chips are soldered on the base plate. The terminals lead from the base plate through the gel, the hardened resin and the lid.

For manufacturing, the gel is filled into the housing at room temperature and is cured at enhanced temperature, typically about 125 °C. On the gel filler a packaging resin is filled and cured. The resin is also cured at enhanced temperature, typically also at 125 °C. Therefore, the gel is thermally expanded when filling in the resin and it shrinks when the module cools down. As the gel sticks to the resin, cracks emerge in the gel. These cracks can lead to partial discharge, thereby damaging or even destroying the module.

JP 10-233472 shows a semiconductor device with means to reduce such cracks. Also, this module comprises a housing with side walls closed on one side of the side walls by a base plate and on the opposite side with a lid. On the base plate semiconductor chips are arranged. In the housing, silicone gel filler is inserted, thus covering the chips. On the gel filler a packaging resin is filled and cured. The lid together with the packaging resin seals the housing from the top. The housing has an L-shaped projection extending from the side walls into the housing, the projection being open to the gel filler, thus forming a space within the housing which is completely sealed against the surrounding. If the gel is expanded due to heat, over pressure is produced in the air-filled space by the expanding gel and the gel presses against the lid and the packaging resin.

### Disclosure of Invention

It is an object of the invention to provide a power semiconductor module with a case filled with a gel layer and above of it, with a hardened resin, in which cracks in the gel due to thermal expansion are avoided.

This object is achieved by a semiconductor module according to claim 1.

The semiconductor module comprises a base plate, at least one semiconductor chip mounted on the base plate, a case fixed to the base plate and surrounds the at least one semiconductor chip, an electrically insulating gel layer covering the at least one semiconductor chip, a thermosetting resin layer on top of gel layer and a lid on top of the thermosetting resin layer. The lid comprises a lid-opening, a lid-layer surrounding the lid-opening and a lid-extension, which extends from the boundary of the lid-opening through the thermosetting resin layer to the gel layer.

By having a lid with such a lid-opening the gel can expand in case of heat within the lid-opening so that the gel can expand more easily. In not sealed gas-tight to the surrounding there is no vacuum or over-pressure in the volume defined by the lid-opening, thereby allowing more easily pressure compensation.

Further preferred embodiments of the inventive subject matter are disclosed in the dependent claims.

### Brief Description of Drawings

The subject matter of the invention will be explained in more detail in the following text with reference to the attached drawings, in which:
- FIG 1: shows a cross sectional view on semiconductor module according to the invention;
- FIG 2: shows a cross sectional view on another embodiment of semiconductor module according to the invention; and
- FIG 3: shows a cross sectional view on another embodiment of semiconductor module according to the invention.

The reference symbols used in the figures and their meaning are summarized in the list of reference symbols. Generally, alike or alike-functioning parts are given the same reference symbols. The described embodiments are meant as examples and shall not confine the invention.

### Modes for Carrying out the Invention

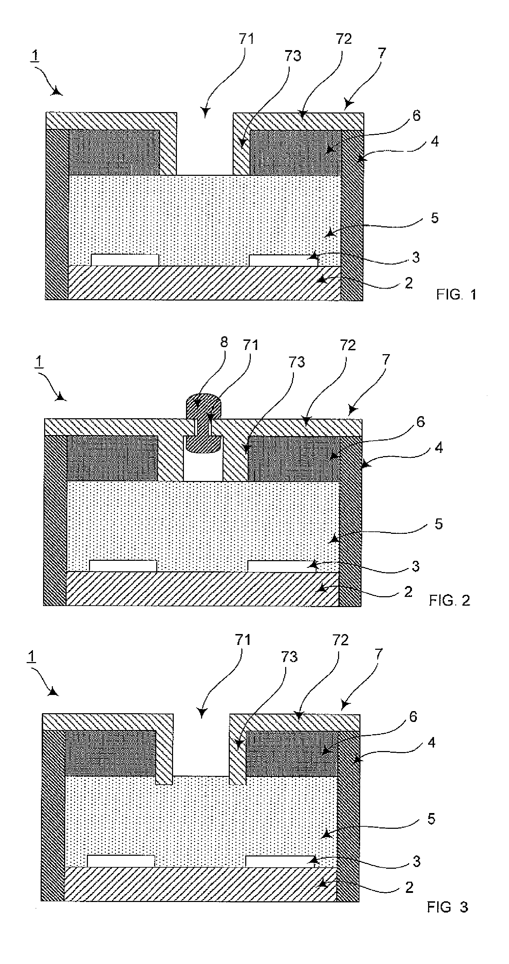

As shown in fig. 1 the semiconductor module 1 according to the invention comprises a base plate 2, at least one semiconductor chip 3 mounted on the base plate 2, a case 4 fixed to the base plate 2 and surrounds the at least one semiconductor chip 3, an electrically insulating gel layer 5 covering the at least one semiconductor chip 3, a thermosetting resin layer 6 on top of gel layer 5 and a lid 7 on top of the thermosetting resin layer 6. Preferably, the material of the gel layer 5 is a silicone gel. The material of the thermosetting resin layer 6 is in particular an epoxy resin.

The lid 7 comprises a lid-opening 71, a lid-layer 72 surrounding the lid-opening 71 and a lid-extension 73 extending from the boundary of the lid-opening 71 through the thermosetting resin layer 6 to the gel layer 5.

In a preferred embodiment the lid-opening 71 allows gas convection, i.e. the lid-opening 71 is open to the environment so that the pressure within the lid-opening 71 is balanced, i.e. the same as in the environment.

In another preferred embodiment, the lid opening 71 lies within an area of the lid layer 72, which is located outside the orthogonal projection of the area in which the at least one chip 3 is located. This location is advantageous, because in case of an explosion, which typically originates in the chips, the thermosetting resin layer 6 and the lid layer 72 prevent that the explosion is directed vertically to the base. Instead the energy is absorbed by the thermosetting resin layer 6 and the lid layer 72 protecting people or other equipment in the vicinity of the module.

Preferably, as shown in fig. 2 the lid opening 71 is closed by a cover 8, especially by a rivet, which allows gas to pass so that pressure within the lid opening 71 under the cover (8) and above the thermosetting resin layer (6) is balanced with the environment pressure. Such a cover 8 prevents dust or other undesired particles to enter the module 1, and avoids under- or overpressure in case of a temperature rise or sinking. The rivet is made of plastics or any other electrically insulating material. In order to have easy manufacturing the rivet can be made as a blind rivet, which can be mounted from the outer side of the module. One-piece blind rivets, such as rivet plugs or slit rivets, as well as two-piece blind rivets, such a two-piece slit rivets, are suitable.

In another preferred embodiment shown in fig. 3, the lid extension 73 extends into the gel layer 5. This makes the manufacturing of the module easier, because less mechanical accuracy is required. During manufacturing after incurring of the gel at enhanced temperature the gel cools down and therefore, sags within the lid opening 71. The lid extension 73 extending into the gel layer 5 ensures that the thermosetting resin, when filled in after having cooled down the gel, cannot flow into the lid opening 71 even if the gel has sagged.

## Claims

1. Semiconductor module (1) comprising
a base plate (2),
at least one semiconductor chip (3) mounted on the base plate (2),
a case (4) fixed to the base plate (2) and surrounds the at least one semiconductor chip (3),
an electrically insulating gel layer (5) covering the at least one semiconductor chip (3),
a thermosetting resin layer (6) on top of gel layer (5),
a lid (7) on top of the thermosetting resin layer (6),
**characterized in that**
the lid (7) comprises a lid-opening (71), a lid-layer (72) on top of the thermosetting resin layer (6) surrounding the lid-opening (71) and a lid-extension (73) extending from the boundary of the lid-opening (71) through the thermosetting resin layer (6) to the gel layer (5).

2. Semiconductor module (1) according to claim 1, **characterized in that** the material of the gel layer (5) is a silicone gel and/or the material of the thermosetting resin layer (6) is an epoxy resin.

3. Semiconductor module (1) according to claim 1 or 2, **characterized in that**
the lid-extension (73) extends into the gel layer (5).

4. Semiconductor module (1) according to any of the claims 1 to 3, **characterized in that**
the lid-opening (71) lies within an area of the lid-layer (72), which is located outside the orthogonal projection of the area in which the at least one chip (3) is located.

5. Semiconductor module (1) according to any of the claims 1 to 4, **characterized in that**
the pressure within the lid-opening (71) is balanced with the pressure of the environment.

6. Semiconductor module (1) according to any of the claims 1 to 4, **characterized in that**
the lid-opening (71) is closed by a cover (8).

7. Semiconductor module (1) according to claim 6, **characterized in that** the cover (8) is a rivet.

8. Semiconductor module (1) according to claim 8, **characterized in that** the rivet is a blind rivet, especially a one-piece or a two-piece blind rivet.

9. Semiconductor module (1) according to claim 7 or 8, **characterized in that**
the rivet is made of electrically insulating material, especially of plastics.

10. Semiconductor module (1) according to any of the claims 6 to 9, **characterized in that**
the pressure within the lid-opening (71) under the cover (8) and above the thermosetting resin layer (6) is balanced with the pressure of the environment.
